# EUROPÄISCHE PATENTSCHRIFT

(11) **EP 2 076 962 B1**
(45) Veröffentlichungstag und Bekanntmachung des Hinweises auf die Patenterteilung: **12.09.2018**
(21) Anmeldenummer: 07818605.3
(22) Anmeldetag: 01.10.2007
(51) Int. Cl.: H03K 17/945, H04B 13/00

(54) **SIGNALVERARBEITUNGSSYSTEM, SOWIE KOMPONENTEN DESSELBEN**
SIGNAL PROCESSING SYSTEM AND COMPONENTS THEREOF
SYSTÈME DE TRAITEMENT DE SIGNAL ET COMPOSANTS DE CE SYSTÈME

(30) Priorität: 29.09.2006 DE 102006046515
(43) Veröffentlichungstag der Anmeldung: 08.07.2009
(73) Patentinhaber: Microchip Technology Germany GmbH, 82205 Gilching (DE)
(72) Erfinder: RICHTER, Wolfgang, 82319 Starnberg (DE)
(74) Vertreter: sgb europe
(86) Internationale Anmeldenummer: PCT/EP2007/008525
(87) Internationale Veröffentlichungsnummer: WO 2008/040517

(56) Entgegenhaltungen:
- WO-A-03/100739
- WO-A-2004/078536
- WO-A-2006/061248
- WO-A-2006/094606
- WO-A-2006/102537
- DE-A1- 10 012 200
- DE-A1- 10 032 864
- DE-A1-102005 038 678
- US-B1- 6 754 472

## Beschreibung

Die Erfindung richtet sich auf ein Signalverarbeitungssystem, sowie auch auf die einzelnen Komponenten dieses Systems an sich. Insbesondere richtet sich die Erfindung hierbei auf ein Signalverarbeitungssystem durch welches innerhalb eines Operationsbereiches eines Anwenders Signale gewonnen werden können auf deren Grundlage Schaltzustände veranlasst werden können die mit Handlungen, Gesten, Stellungen oder anderweitigen für den Schaltzustand maßgeblichen Aktionen des Anwenders korrelieren.

Im vorliegenden Kontext sind unter dem Begriff "Sensor" insbesondere Schalter, Organe zur Erfassung von Druck, Temperatur, Helligkeit, und Kräften sowie Organe zu verstehen die in der Lage sind Zustände und ggf. Zustandsänderungen zu erfassen. Bislang ist es üblich Schaltaktionen eines Anwenders über Sensoren, insbesondere Schalter zu erfassen. Diese Sensoren sind typischerweise mit einer Steuereinrichtung verbunden durch welche die jeweiligen Schaltsignale verarbeitet werden.

Es wird üblicherweise angestrebt die Erfassung entsprechender Signale mit einem möglichst geringen Schaltungsaufwand und Verkabelungsaufwand zu bewerkstelligen. Dies gilt insbesondere für Geräte der weißen Ware (z.B. Waschmaschinen, Geschirrspüler, Öfen, etc.) sowie Kraftfahrzeugausstattungen und - Einbauten, z.B. Fahrzeugsitze, Lenkräder, usw. Unterschiedliche Sensoren, die beispielsweise ein physikalisches Gesamtbild bestimmter Situationen erzeugen sollen, müssen miteinander verbunden sein. Dies geschieht über Bussysteme, oder ggf. auch drahtlos mittels Funktechnik, wobei die Sensoren teilweise mit eigener Energieversorgung (Batterien, Akkus) ausgerüstet sind.

Die Internationale Patentanmeldungsveröffentlichung WO 2006/102537 beschreibt ein tragbares personal area Datennetzwerk.

Es ist Aufgabe der Erfindung, Lösungen anzugeben die es ermöglichen mit relativ geringem Schaltungsaufwand auf kostengünstige Weise mehrere sensorische Aufgaben in einer begrenzten Umgebung zu lösen.

Diese Aufgabe wird erfindungsgemäß durch ein Sensorsystem gemäß Anspruch 1 gelöst. Weitere Ausbildungen sind Gegenstand der Unteransprüche.

Hierdurch wird es auf vorteilhafte Weise möglich die Signale mehrerer Sensoren zu erfassen, ohne dass es hierzu besonderer direkter Verkabelungen zwischen den Sensorkomponenten und der Signal-Requestor-Komponente bedarf.

Vorzugsweise wird das Tell-Signal zu dem Seek-Signal zeitversetzt ausgesendet. Es ist möglich, für die einzelnen Sensorkomponenten verschiedene Delay-Fenster vorzusehen um eine weitgehend kollisionsfreien Datenrückführung zu ermöglichen. Die Delaylänge kann bereits die durch die local-Key Schaltung festgelegte Kennung darstellen.

Es ist auch möglich, das Teil-Signal zumindest phasenweise zeitgleich mit dem Seek-Signal auszusenden. Das Tell-Signal kann insbesondere hierbei durch Impedanzmodulation zu der Schnittstelleneinrichtung der Signal-Seeker-Komponente zurückgeführt werden.

Über das Seek-Signal wird eine der Sensorkomponenten adressiert angesprochen werden. Über das Seek-Signal wird weiterhin Erfindungsgemäß eine Energieversorgung der Sensorkomponenten bewerkstelligt.

Insbesondere bei der Generierung des Sensorsignals als Näherungssensorsignal ist es möglich, über das Seek-Signal das Sensorsignal, z.B. über eine Pegelerfassung zu generieren.

Insbesondere bei der Anwendung des erfindungsgemäßen Sensorsystems bei einem Fahrzeugsitz ist es möglich, dass wenigstens einer der Sensoren ein Drucksensor ist. Das Sensorsystem kann zumindest teilweise unmittelbar in den Fahrzeugsitz, oder eine Sitzumgebung eingebunden sein. Insbesondere ist es möglich, die Signal-Requestor-Komponente im Bereich der Mittelkonsole anzuordnen, so dass diese einen Signaldialog über die Schenkel des Sitznutzers abwickelt. Die Drucksensoren sitzen an den geeigneten Stellen des Sitzes, insbesondere als eingenähte oder aufkaschierte Flachmodule. Über das Sensorsystem kann eine Sitzbelegungsdiskriminierung erfolgen. Nach Maßgabe dieser Sitzbelegungsdiskriminierung kann ein Airbag-System angesteuert werden.

Das System kann mehrere Signal-Requestor-Komponenten umfassen. Diese können auch miteinander in Dialog treten, beispielsweise zur Adressenbestimmung der Sensorkomponenten.

Die Schnittstelleneinrichtung umfasst eine Sendeelektrode und eine Empfangselektrode, wobei die beiden Elektroden voneinander beabstandet angeordnet sind. Der local-key der jeweiligen Sensorkomponente ist vorzugsweise durch die Signal-Requestor-Komponente festlegbar. Über die Signal-Requestor-Komponente kann vorzugsweise die Antwortcharakteristik der jeweilgen Sensorkomponente, insbesondere ein Response-Delay festgelegt werden.

Die Erfindung arbeitet hierbei drahtlos, kontaktlos und ohne dass die Sensorelemente eigene Energiequellen benötigen. Im Gegensatz zu einer selektiven Arbeitsweise arbeitet die Erfindung vorteilhaft simultan. Insbesondere können Menschen und deren Handlungen ein wesentlicher Bestandteil des Sensornetzwerkes sein!

Die Sensorkomponenten können physikalische Aufnehmer für Strom, Spannung, Temperatur, Druck, Feuchtigkeit, Vibration, umfassen die autark nur über das Abfragesignal mit Energie versorgt werden. Die Sensorkomponenten können auch so ausgebildet sein, dass diese in der Lage sind ein "Energy-Harvesting" abzuwickeln, wobei die elektrische Versorgung durch Umwandlung mechanischer oder andere physikalischer Umgebungseffekte erreicht wird (Piezo, Induktion usw.). Deratige Sensoren sind oft mit einer Kommunikationseinrichtung ausgestattet. Mit Hilfe von Protokollen ist es möglich, diese Sensoren auch zyklisch nach einem bestimmten Schema einzustellen und/oder abzufragen.

Auf Grundlage des erfindungsgemäßen Konzepts ist es möglich, mit Hilfe kostengünstig realisierbarer Schaltungen quasi selbstorganisierende Sensornetzwerke aufzubauen, wobei vorteilhafter Weise praktisch keine Kosten für Kabelführung, für Stecker oder Batterien entstehen. Das Netzwerk soll simultan arbeiten und drahtlos versorg- und abfragbar sein. Dabei kann auf aufwändige (und damit kostenintensive) Protokolle verzichtet werden. Aufgrund der Einfachheit der Schaltungsauslegung ist es möglich, zukünftig derartige Sensoren auf Polymerfolien aufzudrucken und diese mit Hilfe von Klebstoff an die zu untersuchenden Stellen anzubringen. Die Erfindung arbeitet kabellos und ist in der Lage, drahtlos die Sensorinformationen simultan an eine Auswertereinheit (Server) zu übertragen, während diese mit Hilfe elektrischer (oder elektromagnetischer) Wechselfelder die Sensoren in ihrer Nähe versorgt. Durch Ändern der Feldstärke ist es möglich, Sensoren ein- und auszuschalten, oder Schaltvorgänge vorzunehmen. Es ist ferner möglich, die Sensoren erst durch einen Menschen in deren Nähe zu aktivieren. Dies kann als bewusste willentliche Handlung oder automatisch durch einen gewissen Abstand zu den Sensoren geschehen.

Die Erfindung ist multifunktionell. Sie benutzt eine metallische oder anders leitende Koppelfläche als Versorgungs-, Sensor- und Kommunikationselement. Auch leitende Fasern (z.B. Carbon) hierzu verwendet werden. Da alle Sensoren simultan arbeiten, entsteht im Server die Möglichkeit, ein Zustandsdiagramm zu schaffen, welches beispielsweise mit Hilfe einer Fourier-Transformation (FFT) ausgewertet werden kann. Da die Sensoren durch mindestens ein elektrisches (oder elektromagnetisches) Feld versorgt (und abgefragt) werden, können auch Veränderungen im Dielektrikum festgestellt und ausgewertet werden. Daher hat die Erfindung vorzugsweise eine pegelrelevante Arbeitsweise (es ist aber auch möglich, mit Hilfe von Frequenz- oder Phasenverschiebung, sowie Pulsweiten zu arbeiten). Die Erfindung erlaubt auch mehrere Server gleichzeitig zu verwenden. Da die Sensoren durch das elektrische Feld versorgt und gleichzeitig abgefragt werden, können diese kontinuierlich auf richtige Funktion überprüft werden (Sensor-"Ok"-Signal). Aufgrund der faradayschen Effekte ist es möglich, innerhalb eines Inertialraumes, z.B. innerhalb einer Maschine, zu wirken. Die Sensorübertragungsfunktion gelangt nicht nach außen und kann damit andere Geräte nicht stören, was bei Funk nicht immer gewährleistet ist.

Weitere Einzelheiten und Merkmale der Erfindung ergeben sich aus der nachfolgenden Beschreibung in Verbindung mit der Zeichnung. Es zeigen:
- **Figuren 1 bis 4, sowie 10 und 11**: Schaltungsdarstellungen zur Veranschaulichung konstruktiver Einzelheiten der Komponenten des erfindungsgemäßen Systems;
- **Figuren 5 bis 9**: Darstellungen zur Veranschaulichung des Einsatzes des erfindungsgemäßen Konzepts bei einem Fahrzeugsitz.

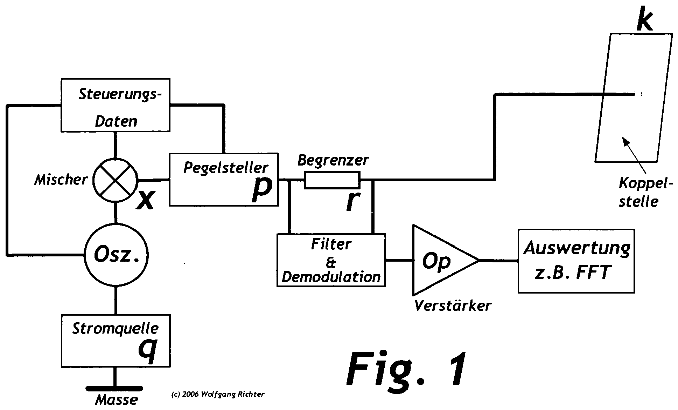

Figur 1 zeigt eine erfindungsgemäße Schaltungsauslegung für den Server (Signal-Requestor Komponente). Eine Stromquelle ***q*** gestattet die Zufuhr elektrischer Energie in bestimmter Weise, z.B. als Konstantstrom. Damit wird ein Oszillator ***(Osz.)*** betrieben, der eine Wechselspannung erzeugen kann (z.B. 200 kHz). Diese Wechselspannung gelangt auf einen Mischer ***x.*** Es ist möglich, über einen Steuerblock diesem Mischer beispielsweise zusätzlich Daten zur Sensorsteuerung zuzuführen. Das gemischte Signal gelangt zu einer Pegelstufe ***p.*** Hier kann mit Hilfe schaltungstechnischer Maßnahmen der Pegel auf ein bestimmtes Maß eingestellt werden. Z.B. würde ein einfacher Serienresonanzkreis es gestatten, den Pegel um einen bestimmten Faktor zu erhöhen, um anschließend ein elektrisches Feld mit genügend großer Übertragungsreichweite zu erzeugen. Eine nachgeschaltete Begrenzung ***r,*** z.B. durch einen Widerstand, erlaubt es, eventuell fließende Ströme, z.B. bei Kurzschluss, nicht über ein bestimmtes Maß hinauswachsen zu lassen. Zum anderen wird genau an diesem Element die von den im Umkreis des elektrischen Feldes betriebenen Sensoren erzeugte Modulation mindestens einer Auswerteeinheit zugeführt. Diese besteht im Wesentlichen aus einem einfachen Filter (z.B. einem Tiefpass, einem Differenzverstärker und/oder einem Transimpedanzverstärker) und führt das ausgefilterte Sensorsignal, welches ein Gemisch aus verschiedenen Frequenzen unterschiedlicher Amplituden sein kann, beispielsweise einer Fourier-Transformation ***FFT*** zu. Die Auswertung kann ebenso mit Hilfe neuronaler Netze oder digital mittels Tondecodern erfolgen. Um das elektrische Feld abzugeben und die Modulation der Sensoren zu empfangen, ist mindestens eine Koppelstelle ***k*** vorgesehen, die beispielsweise aus einer folienartigen Struktur bestehen kann, die wiederum aus leitendem Material ist (Metall, Kunststoff, Kohlefaser, etc.). Von besonderer Bedeutung ist, dass diese Koppelfläche ***k*** auch aus einem resistiven (z.B. Carbonfasern) Material bestehen kann und den erfindungsgemäßen Begrenzungswiderstand ***r*** beinhaltet, was sich wiederum kostengünstig auswirken kann. Ebenfalls möglich ist es, die elektrischen Felder mit Hilfe einer Nadel als starke Punktladung abzustrahlen, um so gezielt Sensorbereiche zu erfassen. Mehrere Server können in einem Inertialraum (Maschine, Kraftfahrzeug, usw.) vorhanden sein. Es können auch unterschiedliche Frequenzen gleichzeitig oder nacheinander benutzt werden, die alle unterhalb einer gewissen Grenze, z.B. 1 MHz, angeordnet sind, um elektromagnetische Abstrahlung zu vermeiden. Somit handelt es sich bei der Erfindung um eine Nahfeld-Kommunikationseinrichtung. Durch Frequenzwechsel während des Betriebes ist auch möglich, die Körperimpedanz eines, sich im Sensorfeld befindlichen Menschen (und somit auch diesen) nachzuweisen.

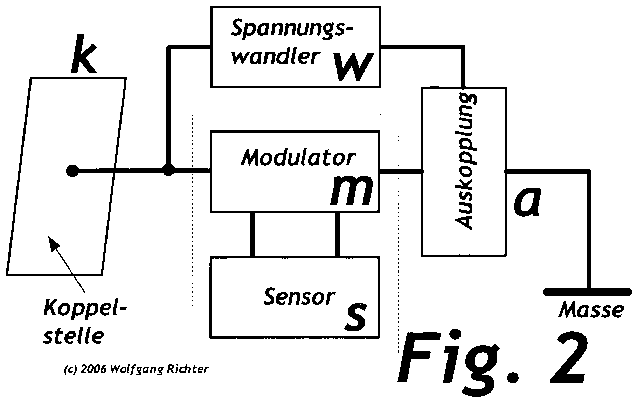

Figur 2 zeigt eine vorteilhafte Schaltungsauslegung für einen Sensor-Client (Sensorkomponente) Da es sich im vorliegenden Fall um eine kapazitive (und/oder elektromagnetische) Kopplung handelt, bestimmt die Größe der Koppelfläche zwischen Server und Client und der Abstand zueinander die Eingangsenergie. Dies ist ein wesentlicher Unterschied zu Funksystemen, bei welchen die Abstrahlung ja durch Antennen erfolgt, die aufgrund ihrer Wellenlänge eine konstante physikalische entsprechende Abmessung haben müssen. Es ist auch das Dielektrikum zwischen den Koppelflächen von Bedeutung, insbesondere, wenn dies veränderbar ist, etwa ein Schaumstoff in einem Kfz-Sitz, der durch das Gewicht eines Menschen eingedrückt wird. Das über die Koppelfläche ***k*** aufgenommene Wechselfeld wird mit einem AC/DC-Wandler ***w*** in eine Gleichspannung gewandelt. Dies kann beispielsweise durch eine Diodenkaskade geschehen, um neben der Gleichrichtung zusätzlich eine entsprechend hohe Arbeitsspannung aus dem Eingangssignal zu erzeugen. Mit dieser Spannung wird mindestens ein Oszillator ***m*** betrieben, der vorzugsweise eine niedrigere Frequenz hat als das einspeisende Wechselspannungssignal. Der Grund hierfür liegt darin, dass es einfacher ist, niedrige Frequenzen z.B. mittels einer Fouriertransformation auszuwerten, da die Auswertung ja auch kostengünstig, z.B. mit 8-Bit-Microcontrollern, erfolgen soll, die oft keine schnellen Rechengeschwindigkeiten erlauben. Entsprechend der Eingangsspannung hat der Oszillator einen gewissen Pegel, mit dem die Eingangsspannung, die ja eine Wechselspannung ist, moduliert werden kann. Hierzu ist ein Modulator vorhanden, der eigentlich aus dem Oszillator selber und einer geeigneten Einkopplung in den Versorgungskreis besteht. Mit Hilfe elektrischer Umwandlung ***s*** von physikalischen Einwirkungsgrößen ist es möglich, den Pegel dieser Spannung (LF) derart zu verändern, dass er proportional zur einwirkenden Größe am Server auswertbar ist und somit ein Maß für die einwirkende Größe bildet. Es ist auch möglich, den LF-Oszillator als VCO auszubilden, damit dieser entsprechend einer (nachzuweisenden) Einwirkung seine Frequenz verändern kann. Die Aktivierung eines Clients erfolgt also immer dann, wenn eine ausreichende Feldstärke vorhanden ist, so dass der Oszillator anschwingt, was gleichzeitig als das zuvor erwähnte "Sensor-Ok"-Signal ausgewertet werden kann. Ein Ausbleiben eines derartigen Signals wäre im FFT-Spektrum der Auswertung als deutliche Lücke erkennbar. Eine beliebige Anzahl Oszillatoren oder Clients kann in einem elektrischen (oder elektromagnetischen Feld) zusammenhängend oder räumlich getrennt vorhanden sein und angesprochen werden. Je nach Abstand entstehen dabei unterschiedliche LF-Oszillatorspannungen, die für jeden Client ein wenig anders in ihrer Frequenz ausgeprägt sein sollen, beispielsweise in 100-Hertz-Schritten getrennt (Tonfrequenz). Somit ist es möglich, in einem Inertialraum (das ist der Raum, der z.B. eine gemeinsame Masse aufweist und/oder sich durch ein ausgegebenes elektrisches (oder elektromagnetsiches) Feld erreichen lässt, z.B. das Innere einer Waschmaschine) mit vielen Sensor-Clients zu beaufschlagen und diese nach deren Aktivierung simultan zu betreiben und abzufragen.

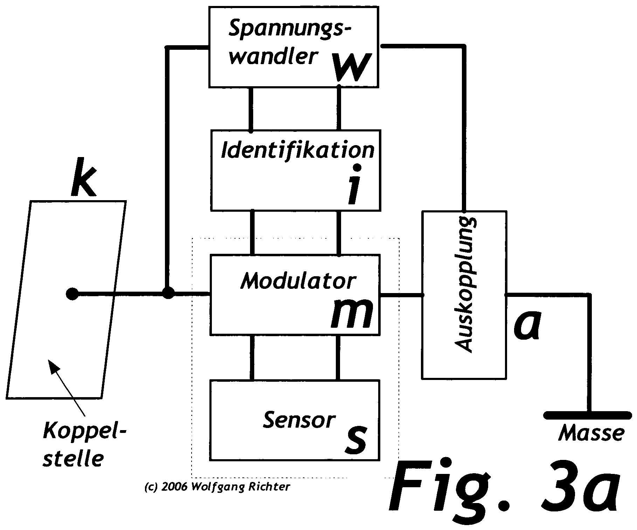

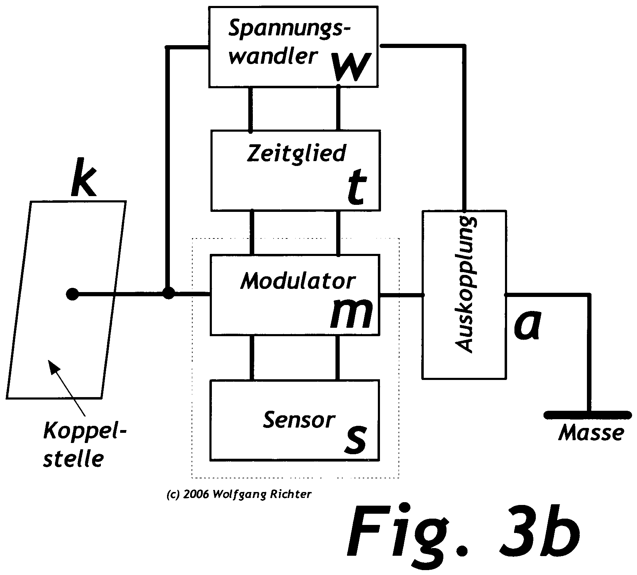

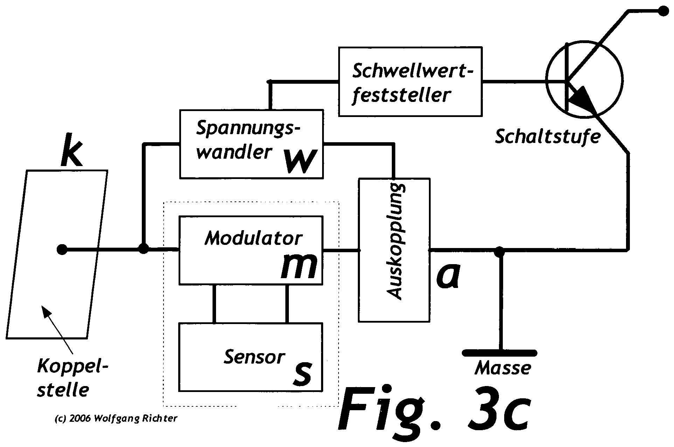

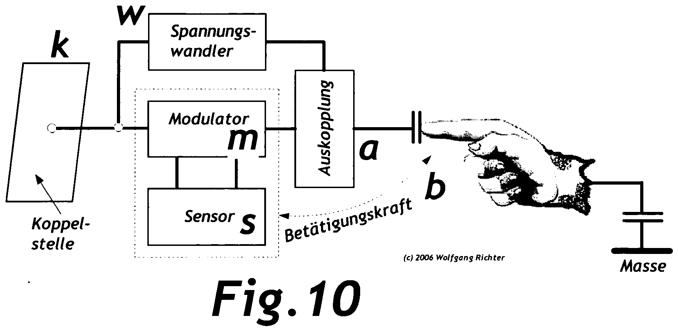

Es ist auch möglich, innerhalb der einzelnen Sensor-Clients mindestens einen Vergleicher ***i*** vorzusehen, der eine vom Server abgegebene Identifikationsnummer vergleicht und erst bei Übereinstimmung den Sensor- und/oder Modulatorteil des Clients aktiviert ***(******Fig.3******).*** Damit wären alle in einem elektrischen (oder elektromagnetischen) Feld befindlichen Sensor-Clients einzeln adressierbar. Die Sensoren würden dann ihre gemessenen Werte wie beschrieben auf das Trägersignal aufmodulieren, bis dieses unterbrochen wird. Damit geht die Identifizierung verloren und es fehlt die Energie zum Betrieb der Sensoren. Dies ist eine sehr einfache Möglichkeit, eine beliebige Anzahl von Sensoren innerhalb eines Inertialraumes zu kontrollieren. Nach Wiederkehr des Trägersignals vom Server kann erneut ein Client (oder mehrere) ausgewählt werden. Aus Kostengründen wird man häufig auf diese Möglichkeit verzichten, d.h. es werden alle Clients, die durch das elektrische Feld versorgt werden, ihre pegelabhängige Sensorfrequenz übermitteln. Dies führt zu einem Frequenzgemisch, das mit Hilfe z.B einer ***FFT*** Fourier-Transformation (beispielsweise im Server oder auch separat) ausgewertet werden kann. Es ist auch möglich, aus den Servern mit Hilfe von Tondecodern eine bestimmte Frequenz heraus zu filtern und diese zu beobachten, falls dies erforderlich ist. Es ist ebenfalls möglich, einen Sensor-Client mit Hilfe eines Zeitglieds (z.B. R/C) ***(******Fig.3b******)*** erst zu einer bestimmten Zeit nach Empfang eines Trägersignals arbeiten zu lassen. Dieses Zeitglied kann auch durch die in der Kaskade anwachsende Gleichspannung gebildet werden, die ab einer bestimmbaren Schaltschwelle (z.B. Schmitt-Trigger) den Oszillator einschaltet. Damit ist es möglich, nach Abgabe des Trägersignals zeitlich aufeinander abgestimmte Sensorsignale von unterschiedlichen Clients zu erhalten. Auch hier erfolgt die Abschaltung wieder simultan durch Wegfallen des Trägersignals. Natürlich ist es möglich, die Arbeitsweise auch bei kontinuierlichem Trägersignal durch einen Abschalt-Timer im Client zu begrenzen. Da ein Sensor-Client nur aus wenigen Bauteilen besteht (Einkoppelfläche, AC/DC-Kaskade, LFO, veränderlicher Widerstand oder veränderliche Kapazität), sollte es möglich sein diese mit Hilfe modernster Technik auf Polymerfolien drucktechnisch aufzubringen. Diese Folien lassen sich biegen und wickeln, um eine bestimmte Ausprägung der Sensorik zu erhalten, was besonders vorteilhaft ist. Dies wird in den beispielhaften Anwendungen noch deutlich. Es ist auch möglich, derartige Sensorelemente als Chip Auszubilden und diese in leitende Polymerfolien einzubetten. Auch ist ein derartiges Sensorelement für die Nanotechnologie geeignet, da es möglich ist, die benötigten Halbleiterstrukturen, Dioden und Transistoren derartig zukünftig auf molekularer Ebene herzustellen und daraus die entsprechenden Schaltungen zu bilden. Aufgrund der geringen Schaltungsanforderung ist es möglich, solche Sensorelemente anreihbar zu gestalten. Normalerweise sind die Sensor-Clients mit einem Pol im Inertialraum gegen Masse galvanisch oder kapazitiv (oder anders) ***a*** verbunden, damit zwischen dem Server und den Clients ein geschlossener Wechselspannungskreis entsteht. Diese Verbindung gegen Ground kann aber auch z.B. durch einen Menschen erfolgen ***(******Fig.10******),*** wenn er einen unge-grounded-ten Client an dessen Ground-Koppelstelle berührt. Die Erdung erfolgt dabei kapazitiv über den Körper des Menschen. Somit kann ein derartiger Sensor auch als drahtloser Tastenersatz dienen oder als durch Berührung aktivierbarer Sensor. Auch hierfür zeigt die Erfindung in der späteren Beschreibung einige Beispiele. Es ist auch möglich durch die Sensor Clients Schaltvorgänge einzuleiten ***(******Fig.3c******).*** Beispielsweise kann eine beaufschlagte Schaltstufe durch einen kurzzeitig erhöhten Einspeisepegel über einen Schwellwertfeststeller (Komparator, Schmitt-Trigger etc.) oder ein mitübertragenes Schaltsignal (mittels Vergleich) aktiviert werden.

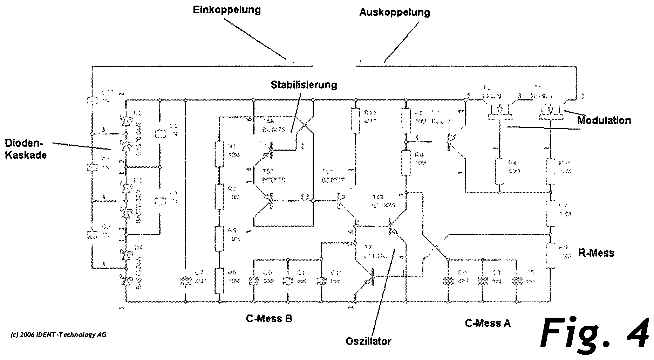

Figur 4 zeigt ein konkretes Schaltungsbeispiel für einen Sensor Client. Um eine möglichst geringe minimal notwendige Betriebsspannung für den Sensor Client zu erlangen, sind zum einen alle seine Verbraucherzweigströme so gering als möglich einzustellen, und zum anderen ist die Strom-Spannungs-Transformation der eingesetzten Dioden-Kaskade speziell in ihrem Leistungsübertragungsfaktor bei kleinen zur Verfügung stehenden Quellströmen zu konzipieren; das dargestellte Design (Fig. 4) dieser Dioden-Kaskade (D2, D3, D4, C12, C1, C2, C6, C4, C7) soll diese Ziele verwirklichen.

Für eine möglichst ausgeprägte Lastmodulation an einem als Stromquelle fungierendem Generator wird das gesamte Netzwerk des Sensor Client mit Hilfe von T1 und T2 von der Quelle abgetrennt - dazu sind die beiden Depletion-MOSFET's antiseriell geschaltet, um in einem Wechselstromkreis eine maximale Abkopplung zu erzielen. Seine 1-Bit breite Information überträgt der Client mit Hilfe eines Amplitudenmodulationston niedriger Frequenz (z.B. 100Hz).

Zur Erzeugung dieses NF-"Tons" sind T4B, T6 und T7 eingesetzt; in ihrem Zusammenspiel wird an dem Kollektor von T6 ein pulsartiger Spannungsverlauf erzeugt, wobei die Pulsbreite durch C8 in Summe mit C3 und C5 und die Pulswiederholfrequenz mit C9 in Summe mit C10 und C11 eingestellt wird.

Damit der Ton eine möglichst geringe Frequenzschwankung in Abhängigkeit der vom Server eingespeisten Ladungsmenge aufweist, ist es notwendig, den Ladevorgang von C9 etc. unabhängig von der Spannung an C7 einzustellen. Hierzu ist das Netzwerk T4A, T5A und T5B mit seiner Beschaltung eingebracht, welches den Kollektorstrom durch den Stromspiegeltransistor T5A benahe unbeeinflusst von dem Spannungspegel an C7 einstellt.

Ein weiterer Gesichtspunkt für die Optimierung des Sensor Client Designs ist die Minimierung der Verzögerungszeit zwischen der Erregung des Clients bis zur Aussendung "seines Tones". Dazu muss die Aufladezeit für das notwendige Betriebspotential minimiert werden und dem entsprechend die Blockkapazitäten im Client; zu kleine Blockkapazitäten führen aber zu einem störendem Rippel in der Betriebsspannung, der der Zielausgangsgröße stets entgegenwirkt. Um diesen Rippel schaltungstechnisch entgegenzutreten, ist dessen Design so ausgelegt, das zum einen der verfügbare Quellstrom in der Durchschaltphase von T4B und T6 direkt in diese fließt (T1 und T2 sind zu diesem Zeitpunkt durchgeschaltet), und zum anderen wird die Amplitudenmodulation im Client nicht durch eine Lastmaximierung erzeugt, was immer zu einem merklichen Abbau von gespeicherten Energien in der Schaltung führen würde, sondern erfindungsgemäß durch eine Lastminimierung, was für die Energien in den Bauelementen ein längst möglichstes Verweilen bedeutet.

Die wichtigsten elektrischen Eigenschaften der beschriebenen Schaltung sind:

| | |
|---|---|
| - minimale Klemmenbetriebspannung an der Koppelstelle | UKmin: ca. 1.5Vss |
| - typische Klemmenbetriebsspannung | UKtyp: 2Vss ... 4Vss |
| - maximale Klemmenbetriebspannung | UKmax: ca. 10Vss |
| - Aufnahmeleistung bei UKtyp=3Vss | nur ca. 0.5µW |
| - Trägerfrequenzbereich F(T): | < 100KHz ... > 200KHz |
| - einstellbarer Frequenzbereich des Tones F(Mod): | ca. 100Hz ... 1000Hz |
| - Frequenzdrift □ ΔF(Mod) (von 2Vss bis 4Vss): | < ± 10% |

### Vorteile der Erfindung gegenüber herkömmlichen Systemen

Die Erfindung ist drahtlos (kein Funk!) und arbeitet vorzugsweise mit einem elektrischen Wechselfeld (E-Feld; B-Feld möglich) mittlerer Frequenz (z.B. 200kHz). Die Sensor-Clients arbeiten kontaktlos, vom Dielektrikum abhängig, von der Größe der Koppelflächen abhängig und vom Speisefeldpegel abhängig. Alle Sensor-Clients arbeiten gleichzeitig. Mit Hilfe eines einzigen Widerstandes erfolgt eine einfache Kanaleinstellung für jeden Client. Somit wirkt die Erfindung selbstorganisierend. Dabei kann die Organisation vom Dielektrikum abhängig sein, von den Koppelflächen oder den Abstand der Koppelflächen zueinander, vom Speisefeldpegel und von sensorbedingten Situationen. Ferner ist die Erfindung selbstversorgend. Sie benötigt keine Batterien, die zus. Verwendung von Akkus (oder Goldcaps) ist möglich, z.B. als Puffer. Alle Sensor-Clients enthalten einen integrierten Spannungswandler ***w,*** der das elektrische Wechselfeld in Gleichspannung in ausreichender Höhe wandeln kann (z.B. Kaskade). Das System benötigt eine minimale Hardware. So sind beispielsweise für einen Client maximal 6 Dioden, 5-8 Transistoren, 10 Kondensatoren und 10 Widerstände nötig. Damit ist die Erfindung geeignet, um drucktechnisch miniaturisiert auf Polymerfolien etc. aufgebracht zu werden. Im Foliendruck könnte eine faltbare Folie mit integrierten Koppelflächen entstehen. Die Sensoren könnten somit unsichtbar in Kraftfahrzeug- oder sonstigen Sitzen, in Lenkrädern, in Schrauben oder unter Abdeckungen oder hinter Blenden angebracht werden.

### Beispielhafte Arbeitsweise der Erfindung

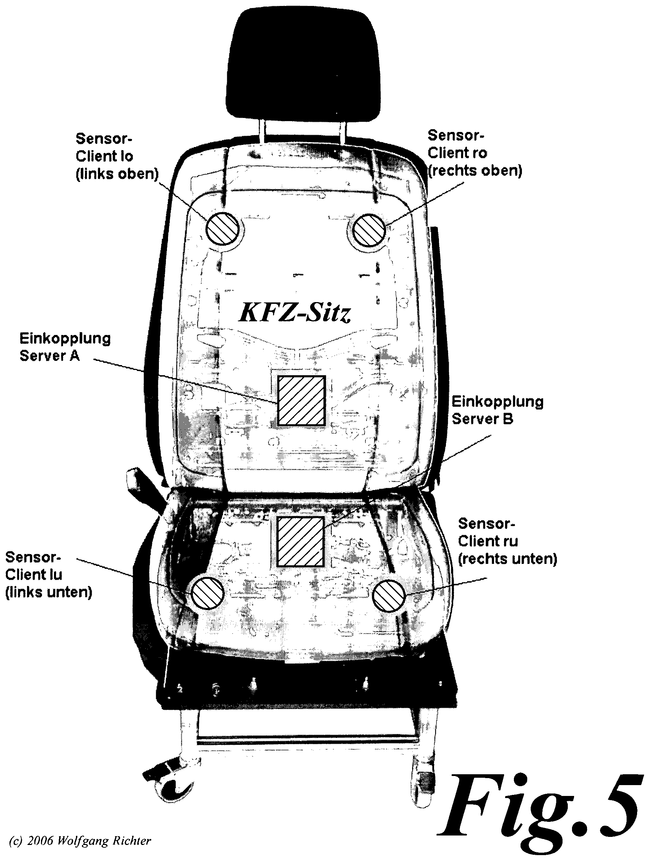

Zunächst erzeugt der Server ***(nach*** ***Fig.1******)*** ein elektrisches Feld, indem er über eine Stromquelle ***q*** einen Generator ***(Osz.)*** betreibt, der wiederum auf einen Pegelwandler ***p*** einwirkt. An einer Strombegrenzung ***r*** wird das elektrische Feld auf eine Koppelfläche ***k*** abgegeben. Es ist möglich (aber nicht unbedingt erforderlich), die Ausgabe dieses Feldes in einen Speise- und einen Abfragezyklus zu unterscheiden. In Reichweite des elektrischen Feldes befinden sich die Sensor-Clients ***(nach*** ***Fig.2******)*** mit ihren Koppelflächen ***k.*** Bei ausreichendem Pegel entsteht an der Diodenkaskade ***w*** eine Gleichspannung, bis eine Arbeitsschwelle erreicht wird. Es ist hier möglich, die Sensoren andauernd zu versorgen oder durch Unterbrechung des Feldes abzuschalten oder die Versorgung und die Arbeitsdauer über einen Timer ***(nach*** ***Fig.3b******)*** einzustellen. Der in den Sensoren vorhandene Generator (Oszillator) ***m*** erzeugt eine Frequenz, die vorzugsweise niedriger ist als die Speisefrequenz. Diese Frequenz kann stabil sein, um den Nachweis zu erbringen, dass ein Sensor sich in Reichweite befindet, z.B. um festzustellen, ob eine Klappe geöffnet oder geschlossen ist. Ebenso kann die Amplitude pegelabhängig sein. Dieser Pegel hängt von der Entfernung zum Speisefeld und zum Dielektrikum oder dessen Beeinträchtigung ab. Die Amplitude kann auch sensorisch ***s,*** von physikalischen Effekten abhängig eingestellt sein, falls dies erforderlich ist. Insgesamt werden nur wenige µ-Ampère zum Betrieb eines Sensor-Clients benötigt. Das durch physikalische Einwirkung in der Amplitude veränderte Oszillator-Signal wird der Trägerfrequenz in geeigneter Weise aufmoduliert und beim Server ***(******Fig.1******)*** am Begrenzerwiderstand ***r*** mittels Filterung, z.B. über Mischer und Tiefpässe, abgenommen und evtl. auch verstärkt. Das Amplitudengemisch kann durch einen Bandpass (oder andere geeignete Filtermaßnahmen) zusätzlich gefiltert werden und einer Analyse, z.B. Fourier-Transformation ***(FFT),*** Wavelets, DFT usw. zugeführt werden. Damit ergibt sich eine simultane Auswertung, ähnl. einer Art Matrix-Demodulation, und die Möglichkeit, alle auf die Sensoren einwirkenden Ereignisse als Zustandsdiagramm auszuwerten ***(vergl.*** ***Fig.5-9******).*** Dies kann auch mit Hilfe von Matrizen oder neuronalen Netzen entstehen. Es ist ebenfalls möglich, mit Hilfe eines durchstimmbaren Filters (z.B. PLL) einen einzelnen Frequenzbereich auszuwählen und zu untersuchen, falls dies erforderlich ist. Falls in den Clients Timer ***(******Fig.3b******)*** vorhanden sind, sind diese an die Messaufgabe anpassbar.

### Beispielhafte Anwendung

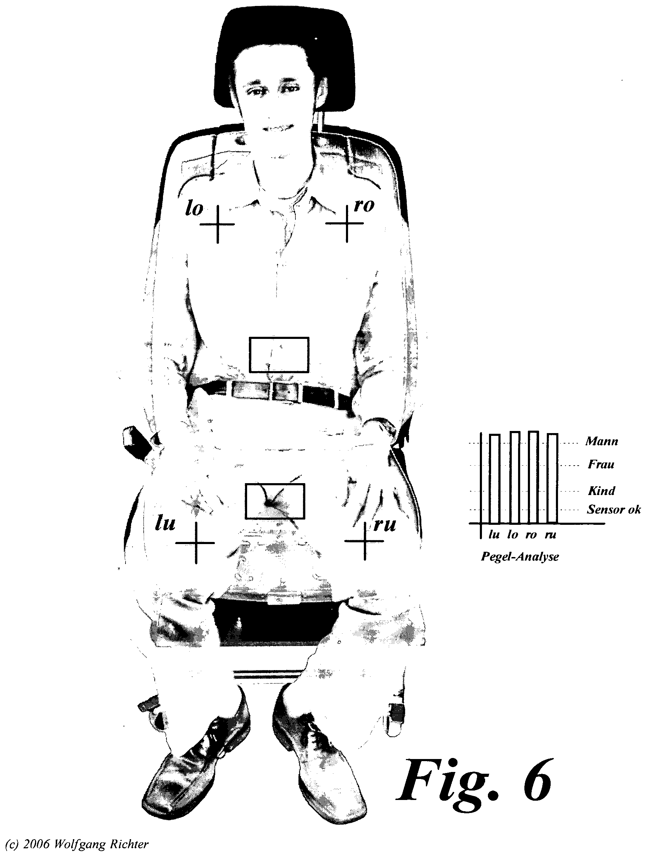

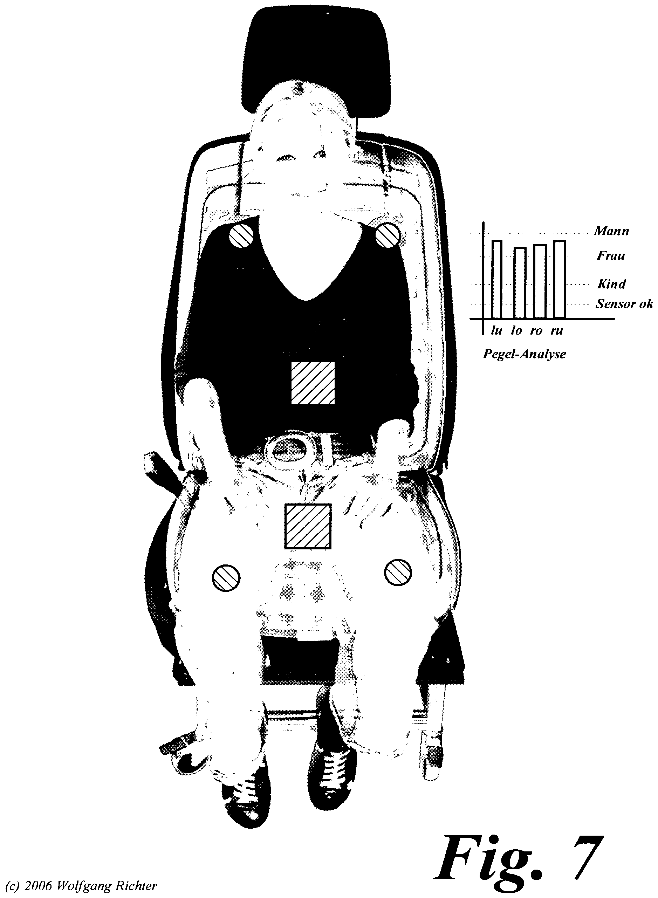

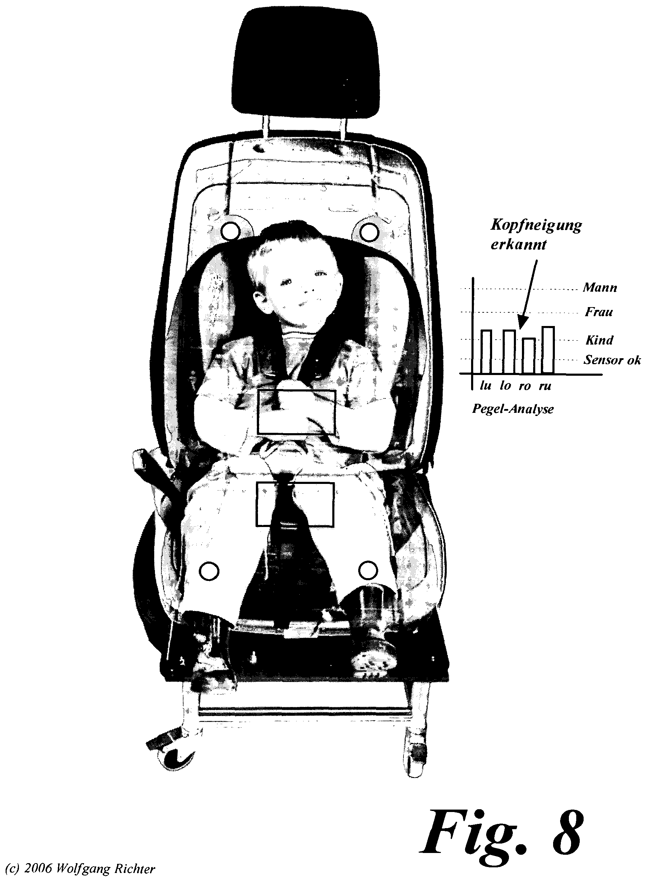

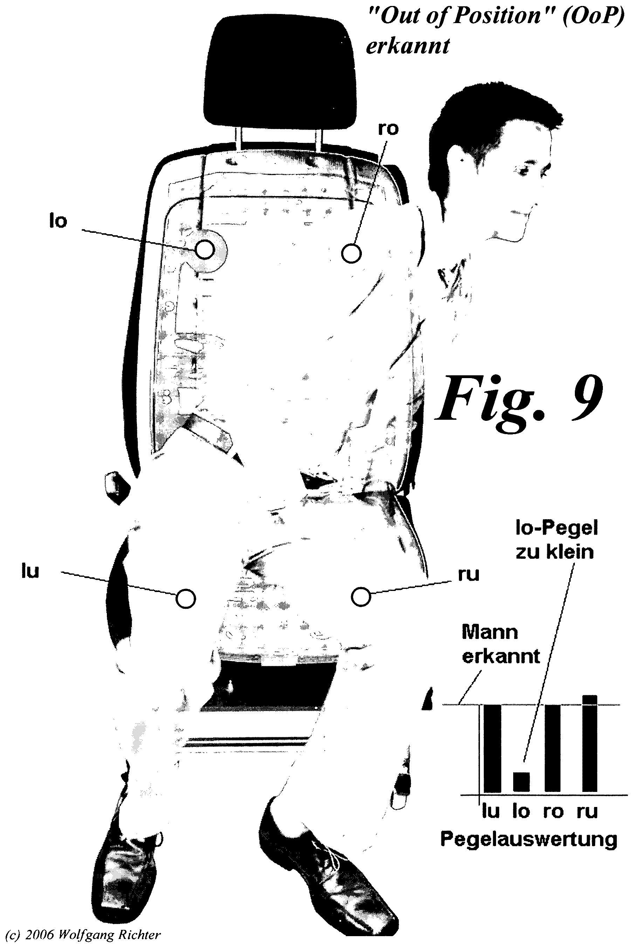

In einem Kfz soll eine klassifizierte Sitzbelegung realisiert werden. Damit ist gemeint, dass Personen unterschiedlichen Gewichts auf dem Sitz sitzen können, was festgestellt werden muss. Diese Personen drücken aufgrund ihres Gewichtes den Polsterschaum eines Sitzes unterschiedlich ein. Wird der Person mit Hilfe einer oder mehrer serverseitigen Koppelstelle(n) ***k*** nach Anordnung ***Fig.5*** ein elektrisches Wechsel-Feld aufgeprägt, so kann es dieses, wie ***Fig.6*** zeigt, über den menschlichen Körper in die Nähe der Koppelflächen der entsprechenden Sensoren gebracht werden. Die Sensor-Clients sind alle gegen Masse geschaltet, so dass die einkommende Energie abhängig ist, je nachdem, wie nah sich ein Mensch an der Sensorkoppelfläche befindet. Dies wiederum hängt von seinem Gewicht und seiner Sitzposition ab. Mit Hilfe einer einfachen Pattern-Analyse in der Auswerteeinheit kann nun festgestellt werden, ob eine Frau ***(******Fig. 7******),*** ein Kind ***(******Fig. 8******)*** oder ein Mann ***(******Fig. 6******)-*** je nach Gewicht - sich auf diesem Sitz befindet. Ferner kann festgestellt werden, ob dieser Mensch symmetrisch auf dem Sitz sitzt, oder ob er seinen Schwerpunkt verlagert hat ***(Out of Position) (******Fig.9******).*** Dies ist wichtig, da insbesondere in einem Kraftfahrzeug der Airbag nur eingeschaltet sein darf, wenn der Mensch sich bestimmungsgemäß verhält. Oftmals ist dies allerdings nicht der Fall. So sind Beifahrer z.B. häufig anzutreffen, die ihre Beine auf dem Armaturenbrett abstützen oder gar im Sommer aus dem Fenster hängen lassen. Hier dürfte ein Airbag bei Gefahr nicht ausgelöst werden, was die Erfindung in vorteilhafter Weise löst. Ferner ist es möglich, mit Hilfe der Erfindung festzustellen, ob der Mensch seinen Oberkörper und/oder seinen Kopf bewegt (Kopfstützennachführung möglich), oder ob er sich angegurtet hat, und wie er sich mit diesem Gurt bewegt. Koppelstellen können auch in Gurten und Polstern durch leitende Fasern oder leitende Farbaufträge realisiert werden. Ein Server kann auch mehrere Auskoppelstellen ***k*** vorweisen, die sich z.B. über einen Multiplexer an- bzw. abschalten lassen.

### Eine weitere beispielhafte Anwendung

soll wiederum in einem Kraftfahrzeug gezeigt werden. Hier ist es möglich, Schalter kontaktlos zu ersetzen. Dabei ist es möglich, bei deren Bedienung Fahrer und Beifahrer zu unterscheiden. Dies geschieht, indem sich z.B. in den Sitzpolstern in den jeweiligen Konsolseiten Abgabeflächen befinden, an die abwechselnd Speisefrequenzen (vom Server) abgegeben werden können. Ein Fahrer oder Beifahrer nimmt diese mit seinem Körper auf und gibt sie mit seinen Händen an mindestens einen Sensor-Client über dessen Einkoppelfläche weiter ***(******Fig.10******).*** Der Client reagiert mit seiner Ton-Frequenz, die anschließend erfindungsgemäß festgestellt wird; somit kann dies als Tastenbedienung gewertet werden. Die Frequenz kann auch durch die Betätigungskraft in ihrer Höhe oder ihrem Pegel verändert werden, so dass auch taktile Rückmeldungen möglich sind. Bei ausreichendem Versorgungspegel ist es möglich, schon bei Annäherung an eine simulierte Taste dies festzustellen (Näherungsdetektion), etwa, um Beleuchtungen vor Tastenbedienung einzuschalten. Das Gleiche gilt für Schalthebel. Auch hier ist eine Fahrer-Beifahrer-Unterscheidung möglich. Es ist auch möglich, die Position von Schalthebeln festzustellen oder im Knauf von Schalthebeln mit Hilfe der Sensor-Clients eine Art Joystick oder Glidepad aufzubauen, welches mit dem Daumen bedient werden kann. Ebenso könnten solche Sensor-Clients an den Pedalen angebracht sein, um die Betätigung selbst oder die Betätigungskräfte oder die Dynamik einer Betätigung festzustellen und zur Auswerteeinrichtung zu übertragen. Die Übertragung geschieht hierbei über den menschlichen Körper, insbesondere über seine Haut (Bodynet). Somit bildet der Mensch praktisch das Dielektrikum zwischen den Koppelflächen. Der zuvor erwähnte Begrenzungswiderstand im Server ***r*** sorgt erfindungsgemäß zusätzlich dafür, dass keine, dem Menschen schädlichen Ströme auftreten können. Es ist auch möglich, mit Hilfe der Sensor-Clients eine Sitzverstellung zu realisieren, die sich beispielsweise auf der Mittelkonsole eines Kraftfahrzeugs befindet und vom Fahrer und Beifahrer abwechselnd betätigt werden kann, wobei sich dadurch der jeweilige Sitz dann verstellen lässt. Um die verschiedenen Freiheitsgrade einzustellen, ist es möglich, in diesen Verstellschalter mehrere Koppelstellen anzubringen und/oder kapazitive Flächen, die bei Betätigung ihre Lage und/oder ihren Abstand zueinander ändern können. Mit Hilfe der erfindungsgemäßen Sensorik ist es auch möglich, innerhalb eines verstellbaren Kraftfahrzeugsitzes eine Art Memory-Funktion zu realisieren, indem die Abstände zu unterschiedlichen Sensor-Clients festgestellt und gespeichert werden können (Soll-Ist-Vergleich).

Von besonderer Bedeutung ist die Anbringung der erfindungsgemäßen Sensor-Clients auch in einem Kraftfahrzeuglenkrad. Hier könnten Schaltwippen simuliert werden. Außerdem ist festzustellen, wie und wo ein Lenkrad angefasst wird, oder ob mit den Knien gelenkt wird. Eine Fahrer- und Beifahrerunterscheidung ist Dabei ebenfalls möglich sowie eine Betätigungsanalyse, wobei die Haltekraft eines Menschen Aufschluss gibt über seine Befindlichkeit (verkrampft, locker, usw.).

### Eine weitere beispielhafte Anwendung

findet sich z.B. in der "weißen Ware" wie wir sie als Waschmaschinen, Geschirrspüler, Herde, Mikrowellen, usw. kennen. Hier leistet die Erfindung zweierlei. Zum einen kann sie die Bedienung erleichtern, indem an Stelle von verdrahten Schaltern, Tasten, Drehschaltern, Schubladenschaltern und Griffschaltern die erfindungsgemäßen drahtlosen Clients verwendet werden. Diese werden durch Annäherung und/oder Berührung eines Menschen aktiviert wie ***Fig.10*** beispielhaft zeigt, und können daher einfach hinter oder auf Blenden aufgebracht (z.B. geklebt) sein. Dies reduziert die Herstellungskosten zum einen, zum anderen kann es Probleme lösen, die mit der Wasserdichtheit zu tun haben.

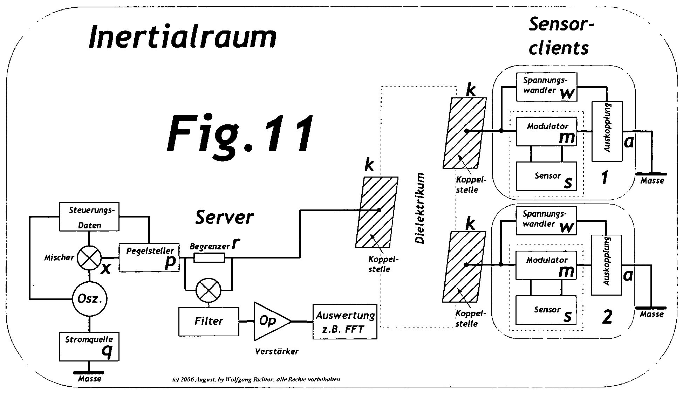

Herkömmliche Tasten und Schalter müssen ja durch eine Blende mit Hilfe von Durchbrüchen geführt werden. Diese sind nur schwer wasserdicht zu machen. Des Weiteren ist es möglich, innerhalb einer Maschine ein Sensornetzwerk aufzubauen, das feststellen kann, ob Klappen oder Ventile geöffnet oder geschlossen sind (auf/zu). Ebenso ist es möglich festzustellen, ob Teile wie z.B. Flusensiebe vorhanden sind oder fehlen. Auch lassen sich der Durchfluss sowie Pegel- und Wasserstände messen. Bei oft motorbetriebenen Geräten können Drehzahlen, Rotationsrichtung, Beladung, Vibration, usw. auf einfache Weise festgestellt werden, da all diese physikalischen Kräfte Änderungen in der Speisefeldstärke hervorrufen können, was sich wiederum direkt auf den abgegeben NF/LF-Oszillatorpegel eines Sensor-Clients auswirken kann. Es ist auch möglich, mit Hilfe eines NTC- oder PTC-Widerstands Temperaturen zu messen und erfindungsgemäß zu übertragen. Oftmals kann ein Sensorelement verschiedene physikalische Größen gleichzeitig übertragen. So ist es möglich, über einen Sensor die Beladung, die Vibration, usw. einer beispielhaften Waschmaschinentrommel vor und während des Betriebs zu messen. ***(******Fig.11******)*** zeigt das Zusammenspiel zwischen Server und Sensor-Clients.

### Universelle Verwendung:

Die Erfindung ist auch für die Verwendung in Sportgeräten geeignet, um die bestimmungsgemäße Verwendung oder die dabei entstehen physikalischen Größen nachzuweisen, oder Unfällen vorzubeugen oder deren Folgen zu mildern.

Schließlich könnte die Erfindung auch im medizintechnischen Bereich eingesetzt werden, etwa um mit Sensoren versehene Implante (im Körper von Mensch oder Tier) zu versorgen und/oder deren Messwerte abzufragen oder von außen am Implantat mechatronische Einstellungen vorzunehmen oder einzuleiten.

Die erfindungsgemäße Auswerteeinheit kann auch vom Pegelsender entfernt angebracht werden, sie muss sich jedoch im Einflussbereich des Wechselfeldes befinden.

Als Tasten verwendete Clients ***(nach*** ***Fig. 10******)*** können mit ***a*** auch direkt oder indirekt mit Masse verbunden sein, z.B. wenn die Clients außen auf einer metallischen Maschinenblende (evtl. mit Erdpotential) angebracht wurden. Ein von einen Server abgegebenes Wechsel-E-Feld muss dann vom Körper eines Menschen aufgenommen und bei Berührung der Koppelfläche ***k*** in den berührten Client eingespeist werden (dazwischen kann sich auch ein Dilelektrikum befinden).

## Patentansprüche

1. Sensorsystem zur Generierung von Steuersignalen die als solche für die Einstellung von Schaltzuständen herangezogen werden, wobei ein in dem Bereich des Sensorsystems befindlicher Anwender als Signalübertragungsstruktur fungiert, mit:
- einer ersten Sensorkomponente die einen Sensor (s), eine erste local-key Schaltung (i), einen ersten AC/DC Wandler (w) und eine erste Signalauskoppelungsschaltung (a) und eine erste kapazitive Koppelungselektrode (k) zur kapazitiven Abstrahlung eines ersten Tell-Signals umfasst, dessen Informationsinhalt indikativ ist für ein durch den ersten Sensor (s) erfasstes Sensorereignis,
- einer zweiten Sensorkomponente die ebenfalls einen Sensor (s), eine zweite local-key Schaltung (i), einen zweiten AC/DC Wandler (w) und eine zweite Signalauskoppelungsschaltung (a) und eine zweite kapazitive Koppelungselektrode (k) zur Abstrahlung eines zweiten Tell-Signals umfasst, dessen Informationsinhalt indikativ ist für ein durch den zweiten Sensor (s) erfasstes Sensorereignis,
- einer Signal-Requestor-Komponente die eine Schnittstelleneinrichtung mit einer Sende- und Empfangselektrode (k) umfasst über welche eine Auskoppelung von Seek-Signalen in den genannten Anwender und eine Einkoppelung von ersten oder zweiten Tell-Signalen aus dem Anwender in die Sende- und Empfangselektrode bewerkstelligt wird, wobei die beiden Elektroden von einander beabstandet angeordnet sind,
- wobei die jeder Sensorkomponente zugeordnete erste oder zweite local-key Schaltung (i) derart ausgebildet ist, dass das erste oder zweite Tell-Signal einen Informationsinhalt trägt der eine Zuordnung des ersten oder zweiten Tellsignals zu der jeweiligen Sensorkomponente ermöglicht,
- wobei das erste oder zweite Tell-Signal und das Seek-Signal über einen Körper des Anwenders kapazitiv übertragen werden, und
wobei über das Seek-Signal eine Energieversorgung der Sensorkomponenten erfolgt, wobei die Koppelungselektroden (k) der Sensorkomponenten und die Sende- und Empfangselektrode (k) der Signal-Requestor-Komponente jeweils eine Koppelfläche aufweisen deren Größe eine Energieübertragung an die jeweilige Sensorkomponente mittels des Seek-Signals gestattet, wobei eine Stromversorgung der ersten oder zweiten Sensorkomponente durch den ersten oder zweiten AC/DC Wandler (w) erfolgt welchem das Seek-Signal zugeführt wird.

2. Sensorsystem nach Anspruch 1, **dadurch gekennzeichnet, dass** das erste oder zweite Tell-Signal zu dem Seek-Signal zeitversetzt ausgesendet wird.

3. Sensorsystem nach Anspruch 1, **dadurch gekennzeichnet, dass** das erste oder zweite Tell-Signal zumindest phasenweise zeitgleich mit dem Seek-Signal ausgesendet wird.

4. Sensorsystem nach wenigstens einem der Ansprüche 1 bis 3, **dadurch gekennzeichnet dass** das erste oder zweite Tell-Signal durch Impedanzmodulation erzeugt wird.

5. Sensorsystem nach wenigstens einem der Ansprüche 1 bis 4, **dadurch gekennzeichnet, dass** über das Seek-Signal eine der Sensorkomponenten adressiert angesprochen wird.

6. Sensorsystem nach wenigstens einem der Ansprüche 1 bis 5, **dadurch gekennzeichnet, dass** über das Seek-Signal ein Sensorsignal generiert wird.

7. Sensorsystem nach wenigstens einem der Ansprüche 1 bis 6, **dadurch gekennzeichnet, dass** wenigstens einer der Sensoren ein Drucksensor ist.

8. Sensorsystem nach wenigstens einem der Ansprüche 1 bis 7, **dadurch gekennzeichnet, dass** wenigstens einer der Sensoren ein Näherungssensor ist.

9. Sensorsystem nach wenigstens einem der Ansprüche 1 bis 8, **dadurch gekennzeichnet, dass** das Sensorsystem in einen Fahrzeugsitz, oder eine Sitzumgebung eingebunden ist.

10. Sensorsystem nach Anspruch 9, **dadurch gekennzeichnet, dass** über das Sensorsystem eine Sitzbelegungsdiskriminierung erfolgt.

11. Sensorsystem nach Anspruch 10, **dadurch gekennzeichnet, dass** nach Maßgabe dieser Sitzbelegungsdiskriminierung ein Airbag-System angesteuert wird.

12. Sensorsystem nach wenigstens einem der Ansprüche 1 bis 11, **dadurch gekennzeichnet, dass** das System mehrere Signal-Requestor-Komponenten umfasst.

13. Sensorsystem nach wenigstens einem der Ansprüche 1 bis 12, **dadurch gekennzeichnet, dass** das System eine Vielzahl von Sensorkomponenten umfasst.

14. Sensorsystem nach wenigstens einem der Ansprüche 1 bis 13, **dadurch gekennzeichnet, dass** der local-key der jeweiligen Sensorkomponente durch die Signal-Requestor-Komponente festlegbar ist.

15. Sensorsystem nach wenigstens einem der Ansprüche 1 bis 14, **dadurch gekennzeichnet, dass** über die Signal-Requestor-Komponente die Antwortcharakteristik der jeweilgen Sensorkomponente, insbesondere ein Response-Delay festlegbar ist.

## Claims

1. A sensor system for generating control signals which as such are used for setting switching states, wherein a user located in the area of the sensor system serves as a signal transfer structure, comprising:
- a first sensor component which comprises a sensor (s), a first local key circuit (i), a first AC-DC-converter (w) and a first signal decoupling circuit (a) and a first capacitive coupling electrode (k) for capacitively emitting a first tell signal, whose information content is indicative for a sensor event recorded by the first sensor (s),
- a second sensor component which also comprises a sensor (s), a second local key circuit (i), a second AC-DC-converter (w) and a second signal decoupling circuit (a) and a second capacitive coupling electrode (k) for emitting a second tell signal, whose information content is indicative for a sensor event recorded by the second sensor (s),
- a signal requestor component which comprises an interface device comprising an emitting and receiving electrode (k) by means of which a decoupling of seek signals into said user and a coupling of first or second tell signals from the user into the emitting and receiving electrode is carried out, wherein the two electrodes are arranged spaced apart from each other,
- wherein the first or second local key circuit (i) associated with each sensor component is formed such, that the first or second tell signal carries an information content which allows a mapping of the first or second tell signal with the respective sensor component,
- wherein the first or second tell signal and the seek signal are emitted capacitively by means of a body of the user, and
wherein a power supply of the sensor components is carried out by means of the seek signal, wherein the coupling electrodes (k) of the sensor components and the emitting and receiving electrode (k) of the signal requestor component each have a coupling face whose size allows a power transmission to the respective sensor component by means of the seek signals, wherein a power supply of the first or second sensor component is carried out by means of the first or second AC-DC-converter (w) to which the seek signal is fed.

2. The sensor system of claim 1, **characterized in that** the first or second tell signal is emitted time-displaced with respect to the seek signal.

3. The sensor system of claim 1, **characterized in that** the first or second tell signal at least in phases is emitted simultaneously with the seek signal.

4. The sensor system of at least one of claims 1 to 3, **characterized in that** the first or second tell signal is generated by impedance modulation.

5. The sensor system of at least one of claims 1 to 4, **characterized in that** one of the sensor components is activated in an addressed manner by means of the seek signal.

6. The sensor system of at least one of claims 1 to 5, **characterized in that** a sensor signal is generated by means of the seek signal.

7. The sensor system of at least one of claims 1 to 6, **characterized in that** at least one of the sensors is a pressure sensor.

8. The sensor system of at least one of claims 1 to 7, **characterized in that** at least one of the sensors is a proximity sensor.

9. The sensor system of at least one of claims 1 to 8, **characterized in that** the sensor system is integrated into a vehicle seat or a seat environment.

10. The sensor system of claim 9, **characterized in that** a seat occupancy discrimination is carried out by means of the sensor system.

11. The sensor system of claim 10, **characterized in that** an airbag system is actuated in accordance with this seat occupancy discrimination.

12. The sensor system of at least one of claims 1 to 11, **characterized in that** the System comprises several signal requestor components.

13. The sensor system of at least one of claims 1 to 12, **characterized in that** the system comprises a plurality of sensor components.

14. The sensor system of at least one of claims 1 to 13, **characterized in that** the local key of the respective sensor component may be set by the signal requestor component.

15. The sensor system of at least one of claims 1 to 14, **characterized in that** the response characteristics of the respective sensor component, particularly a response delay, may be set by means of the signal requestor component.

## Revendications

1. Système de capteur pour la génération de signaux de commande qui sont utilisés en tant que tels pour le réglage d'états de commutation, un utilisateur se trouvant dans la zone du système de capteur fonctionnant comme une structure de transmission de signaux, avec :
- un premier composant de capteur qui comprend un capteur (s), un premier circuit de clé locale (i), un premier convertisseur AC/DC (w) et un premier circuit de découplage de signaux (a) et une première électrode de couplage capacitif (k) pour l'émission capacitive d'un premier signal Tell, dont le contenu d'informations indique un événement de capteur mesuré par le premier capteur (s),
- un deuxième composant de capteur qui comprend également un capteur (s), un deuxième circuit de clé locale (i), un deuxième convertisseur AC/DC (w) et un deuxième circuit de découplage de signaux (a) et une deuxième électrode de couplage capacitif (k) pour l'émission capacitive d'un deuxième signal Tell, dont le contenu d'informations indique un événement de capteur mesuré par le deuxième capteur (s),
- un composant demandeur de signaux qui comprend un dispositif d'interface avec une électrode d'émission et de réception (k), par l'intermédiaire duquel un découplage de signaux Seek dans l'utilisateur mentionné et un couplage des premiers ou deuxièmes signaux Tell provenant de l'utilisateur dans l'électrode d'émission et de réception, est réalisé, les deux électrodes étant écartées l'une de l'autre,
- le premier ou le deuxième circuit de clé locale (i) correspondant à chaque composant de capteur étant conçu de façon à ce que le premier ou le deuxième signal Tell porte un contenu d'informations qui permet une attribution du premier ou du deuxième signal Tell au composant de capteur correspondant,
- le premier ou le deuxième signal Tell et le signal Seek sont transmis de manière capacitive par l'intermédiaire d'un corps de l'utilisateur et
moyennant quoi, par l'intermédiaire du signal Seek, a lieu une alimentation en énergie des composants du capteur, les électrodes de couplage (k) des composants du capteur et l'électrode d'émission et de réception (k) du composant demandeur de signaux présentant chacun une surface de couplage dont la taille permet une transmission d'énergie au composant de capteur correspondant au moyen du signal Seek, une alimentation en énergie du premier ou du deuxième composant de capteur ayant lieu à l'aide du premier ou du deuxième convertisseur AC/DC (w), auquel le signal Seek est appliqué.

2. Système de capteur selon la revendication 1, **caractérisé en ce que** le premier ou le deuxième signal Tell est émis de manière décalée dans le temps par rapport au signal Seek.

3. Système de capteur selon la revendication 1, **caractérisé en ce que** le premier ou le deuxième signal Tell est émis au moins en phase de manière synchrone avec le signal Seek.

4. Système de capteur selon l'une des revendications 1 à 3, **caractérisé en ce que** le premier ou le deuxième signal Tell est généré par modulation d'impédance.

5. Système de capteur selon l'une des revendications 1 à 4, **caractérisé en ce que**, par l'intermédiaire du signal Seek, un des composants est abordé de manière adressée.

6. Système de capteur selon l'une des revendications 1 à 5, **caractérisé en ce que**, par l'intermédiaire du signal Seek, un signal de capteur est généré.

7. Système de capteur selon l'une des revendications 1 à 6, **caractérisé en ce qu'**au moins un des capteurs est un capteur de pression.

8. Système de capteur selon l'une des revendications 1 à 7, **caractérisé en ce qu'**au moins un des capteurs est un capteur de proximité.

9. Système de capteur selon l'une des revendications 1 à 8, **caractérisé en ce que** le système de capteur est intégré dans un siège de véhicule ou un environnement de siège.

10. Système de capteur selon la revendication 9, **caractérisé en ce que**, par l'intermédiaire du système de capteur, a lieu une discrimination d'occupation du siège.

11. Système de capteur selon la revendication 10, **caractérisé en ce que**, conformément à cette discrimination d'occupation du siège, un système d'airbag est contrôlé.

12. Système de capteur selon l'une des revendications 1 à 11, **caractérisé en ce que** le système comprend plusieurs composants demandeurs de signaux.

13. Système de capteur selon l'une des revendications 1 à 12, **caractérisé en ce que** le système comprend une pluralité de composants de capteurs.

14. Système de capteur selon l'une des revendications 1 à 13, **caractérisé en ce que** la clé locale du composant de capteur peut être définie par le composant demandeur de signaux.

15. Système de capteur selon l'une des revendications 1 à 14, **caractérisé en ce que**, par l'intermédiaire du composant demandeur de signaux, la caractéristique de réponse du composant de capteur correspondant, plus particulièrement un retard de réponse, peut être définie.
